(19) Europäisches Patentamt
European Patent Office
Office européen des brevets

(11) EP 4 776 002 A1

(12) EUROPEAN PATENT APPLICATION

(43) Date of publication:
15.07.2026 Bulletin 2026/29

(51) International Patent Classification (IPC):
*G01R 29/08* (2006.01)

(21) Application number: 26151633.0

(22) Date of filing: 13.01.2026

(52) Cooperative Patent Classification (CPC):
G01R 29/0885

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 13.01.2025 EP 25151505
08.08.2025 IT 202500021148

(71) Applicant: Thales Alenia Space Italia S.p.A. Con
Unico Socio
00131 Roma (IT)

(72) Inventors:
• TOMARCHIO, Luca
00131 Roma (IT)
• DABAS, Andres Matias
00131 Roma (IT)
• CATUOGNO, Tommaso
00131 Roma (IT)
• VERDUCCI, Mattia
00131 Roma (IT)

(74) Representative: Studio Torta S.p.A.
Via Viotti, 9
10121 Torino (IT)

(54) **RADIOFREQUENCY SENSOR BASED ON A LIGHT-ATOM QUANTUM INTERFEROMETER WITH ALKALI ATOMIC VAPOR CELL**

(57) The present invention concerns a radiofrequency sensor comprising: a light-atom interferometer including an alkali atomic vapor cell; at least a laser operable to illuminate the alkali atomic vapor cell with laser light to measure a radiofrequency oscillating magnetic field in terms of light intensity modulation, wherein said radiofrequency oscillating magnetic field induces a phase change in the alkali atomic vapor cell based on AC Zeeman effect; and a photodetector configured to detect the laser light from the alkali atomic vapor cell.

FIG. 4

Description

## CROSS-REFERENCE TO RELATED APPLICATIONS

This patent application claims priority from European patent application no. 25151505.2 filed on January 13, 2025, and from Italian patent application no. 102025000021148 filed on August 8, 2025, the entire disclosure of which is incorporated herein by reference.

## TECHNICAL FIELD OF THE INVENTION

The present invention relates to a radiofrequency (RF) sensor based on a light-atom quantum interferometer with alkali atomic vapor cell.

## STATE OF THE ART

As is known, rapid evolution of communication technologies and growing complexity of communication systems require development of advanced radiofrequency (RF) sensors that offer broader bandwidth and enhanced performance in increasingly crowded RF environments. Current devices and sensors must be miniaturized and energy-efficient, especially for deployment in small, battery-operated Internet-of-Things (IoT) devices. Additionally, there is a demand for improved interference rejection and dynamic spectrum access capabilities. Despite various advancements, existing RF sensing solutions often fail to meet these critical requirements effectively.

Such sensors are essential for satellite communication systems, enabling high data rates and reliable connectivity for television broadcasting, data transmission, and inter-satellite links. In military and defense sectors, these RF sensors play a crucial role in electronic warfare, radar systems and surveillance, providing real-time monitoring and jamming capabilities over a broad frequency spectrum. The industrial sector similarly benefits, as these sensors can enhance wireless communication within smart factories and the Industrial Internet of Things (IIoT).

Additionally, in aerospace and avionics, RF sensors are employed for seamless communication between aircraft and ground stations, as well as for precise navigation systems.

Research applications, such as radio astronomy, require RF sensors that can capture faint signals from space, while medical devices benefit from reliable wireless telemetry systems for patient monitoring.

Given this extensive range of applications, it is clear that there is a pressing need for novel RF sensor devices that can provide extensive bandwidth and robust performance across the desired frequency range, facilitating improved monitoring and analysis in a multitude of applications.

Examples of technologies for detecting, measuring and/or processing RF signals in various applications are Microstrip and Patch Antennas, micro-electromechanical systems (MEMS), Photonics-Based RF Sensors, Phased Array and Smart Antennas, quantum RF antennas like Rydberg sensors, and wideband antennas like Ultra-Wide Band (UWB), Vivaldi and horn antennas. These technologies exhibit certain advantages, particularly in terms of sensitivity and operational bandwidth. However, despite the technical advantages of the state-of-the-art RF sensing technologies, many of them have significant drawbacks. Limitations such as antenna size, restricted bandwidth, and suboptimal sensitivity hinder their effectiveness. For instance, classical wideband antennas typically require larger dimensions to achieve high sensitivity, thus limiting their application in compact designs. Although already known quantum sensors like Rydberg atom sensors present substantial benefits, they inherently measure only single frequencies across a broad range (from GHz to THz) and necessitate precise calibration for each specific wavelength.

Advanced photonic RF sensors can handle high-frequency signals effectively. However, their dynamic range may be limited in certain applications, making them less suitable for environments with significant variations in signal strength. Moreover, if not properly calibrated or designed, optical components in photonic sensors can introduce signal distortions, particularly when dealing with high-frequency signals or requiring precise measurements.

## OBJECT AND SUMMARY OF THE INVENTION

An object of the present invention is that of providing a technical solution, in particular a radiofrequency (RF) sensor, such that to alleviate, at least in part, the technical drawbacks of the RF sensors currently known.

This and other objects are achieved by the present invention in that it relates to a device for sensing RF signals, as defined in the appended claims.

In particular, the device for sensing RF signals according to the present invention comprises:

- a light-atom quantum interferometer including an alkali atomic vapor cell;
- lasers operable to illuminate the alkali atomic vapor cell with laser light to measure a RF oscillating magnetic field present in said alkali atomic vapor cell, wherein said RF oscillating magnetic field induces a phase change in the alkali atomic vapor based on AC Zeeman effect thereby inducing an intensity modulation of the laser light; and
- a photodetector configured to detect/measure the laser light from the alkali atomic vapor cell.

## BRIEF DESCRIPTION OF THE DRAWINGS

For a better understanding of the present invention, preferred embodiments, which are intended purely by way of non-limiting, non-binding examples, will now be described with reference to the attached drawings (all not to scale), wherein:

- Figure 1 shows a comparison between a classical Mach-Zehnder interferometer and a quantum SU(1,1) interferometer;
- Figure 2 shows Raman amplification process;
- Figure 3 schematically illustrates some elements of an RF sensor according to an embodiment of the present invention;
- Figure 4 schematically illustrates an RF sensor according to an embodiment of the present invention;
- Figure 5 shows an example of RF sensor interferometric reading according to an embodiment of the present invention.

## DESCRIPTION OF EMBODIMENTS OF THE INVENTION

The following description is presented to enable a person skilled in the art to comprehend, make and use the invention. Various modifications to the embodiments will be readily apparent to those skilled in the art, without departing from the scope of the present invention as claimed. Thence, the present invention is not intended to be limited to the embodiments shown and described but is to be accorded the widest scope of protection consistent with the features defined in the appended claims.

The present invention concerns a device for sensing radiofrequency (RF) signals, said device comprising:

- a light-atom interferometer including an alkali atomic vapor cell;
- lasers operable to illuminate the alkali atomic vapor cell with laser light to measure a RF oscillating magnetic field present in said alkali atomic vapor cell, wherein said RF oscillating magnetic field induces a phase change in the alkali atomic vapor based on AC Zeeman effect thereby inducing an intensity modulation of the laser light; and
- a photodetector configured to detect/measure the laser light from the alkali atomic vapor cell.

Preferably, the light-atom interferometer is a quantum SU(1,1) interferometer.

Conveniently, the alkali atomic vapor cell is based on rubidium or cesium atoms.

The RF sensor preferably comprises also an optical delay line for propagation of the laser light outside the alkali atomic vapor cell and an optical control unit configured/operable to set optical delay length of the optical delay line to tune sensitivity and dynamic range of the device for sensing RF signals.

Moreover, the device for sensing RF signals conveniently comprises also a processing unit programmed to:

- receive from the photodetector data related to the laser light detected/measured by said photodetector;
- carry out a processing of the received data; and
- determine an incident RF signal based on the processing carried out.

The present invention concerns the technical domain of radiofrequency (RF) sensing and detection systems. Specifically, it relates to RF sensors designed for measuring and monitoring electromagnetic waves in a variety of applications and environments, including signal strength measurement, spectral analysis, electromagnetic field mapping, satellite communication systems and spaceborne RF sensing technologies. The invention exploits advanced sensor materials and quantum techniques to enhance sensitivity, accuracy, and versatility of RF measurements in real-time environments or environments characterized by extreme conditions, such as outer space applications, variable signal attenuation, broadband signal frequency change, and detection of passive signals of opportunity.

The present invention concerns exploitation of a quantum interferometer, based on nonlinear interaction between laser light and an atomic vapor, as a tunable sensor for RF signals in the super high frequency (SHF) spectrum (i.e., 3 to 30 GHz). The technology includes a fully fiber-integrated sensor, with the vapor cell as the sensitive part, that uses laser light as a probe for the atomic vapor phase that evolves at the presence of an external electromagnetic field. The system conveniently comprises:

- a plurality of laser sources;
- a laser locking system;
- a sensor cell filled with an alkali gas;
- a tunable optical delay line; and
- an optical detector.

The invention can be used for the simultaneous detection of RF signals at different frequencies across the SHF spectrum, with a sensitivity surpassing the shot noise limit affecting classical sensors and with sensor dimensions breaking the Chu limit of classical antennas.

The invention can be exploited in a wide range of industries and applications where RF sensing and monitoring are critical. Key sectors include wireless communication systems, electromagnetic compatibility (EMC) testing, military and defense operations, consumer electronics, and satellite communication, particularly in earth observation, communications, and navigation satellites.

The solution according to the present invention includes a radiofrequency (RF) antenna based on an alkali atomic vapor whose phase changes, as induced by the RF waves magnetic field, are probed through a light-atom SU(1,1) interferometer.

A light-atom interferometer (cf. Atom light hybrid interferometer, Phys. Rev. Lett. 115, 043602 (2015)) consists of a quantum interferometer where the spin-wave of an alkali atomic vapor takes the place of one of the two light branches of classical interferometers (Mach-Zehnder) and a Raman amplification process works as a nonlinear beam splitter. An interferometer can be used as a sensor since it is sensible to the relative phase changes between the two branches. In a classical interferometer, the phase of light can be changed by the presence of different mediums during propagation. For a light-atom interferometer, instead, the change in phase takes place in an atomic vapor cell, whose quantum state is affected by the presence of electromagnetic radiation. This phase change is probed by laser light and translates into an intensity modulation read by a photodetector.

The nonlinear nature of the wave splitting is a key ingredient for the technology. A nonlinear process grants the interaction and entanglement of the phase between photons and atoms. Moreover, it permits to overcome the shot noise limit that affects classical interferometers. These nonlinear interferometers are called SU(1,1) (cf. Quantum SU(1,1) interferometers: Basic principles and applications, APL Photon. 5, 080902 (2020); Improvement of phase sensitivity in SU(1,1) interferometer using number-conserving operations, Results in Physics 58 (2024) 107465) and produce two beams whose fields are entangled due to the parametric amplification process.

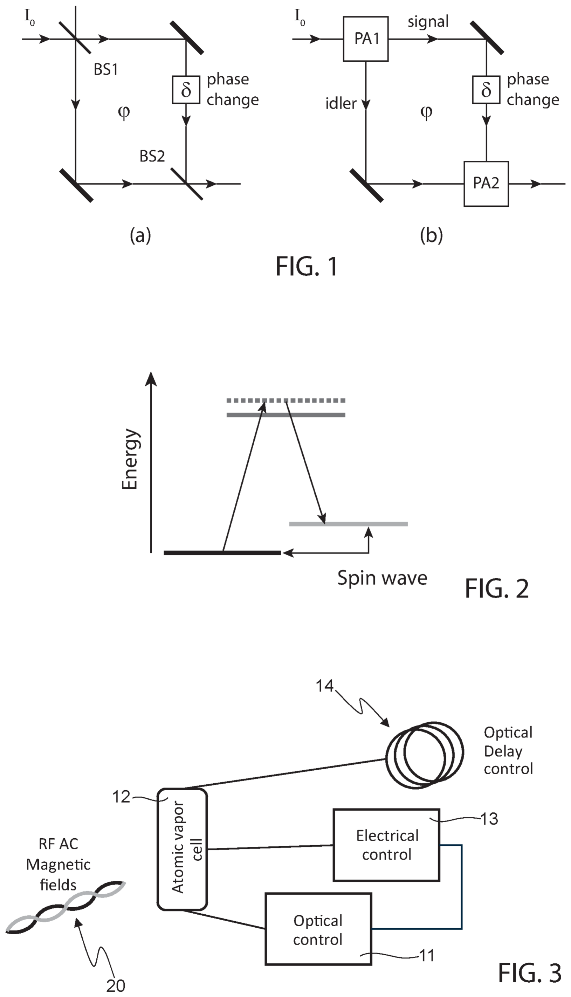

Figure 1 shows a comparison between a classical Mach-Zehnder interferometer (on the left - Figure 1(a)) and a SU(1,1) interferometer (on the right - Figure 1(b)). In traditional interferometry, as shown in Figure 1(a), an input field is split into two by a beam splitter (BS1). One of the beams, serving as the probe, is phase modulated so as to encode a phase change ($\delta$) onto it. It then interferes with the other beam, serving as a reference, at another beam splitter (BS2). This converts the phase change to an intensity change, and the outputs of BS2 are directly measured and analysed with intensity detectors. Regardless of the difference in design between different schemes, the sensitivity of traditional interferometers is limited by the vacuum quantum noise or the so-called shot noise inherited from the input field and the vacuum field injected from the unused BS input ports1 (dashed line in Figure 1(a)). The sensitivity limit of this kind of interferometer is referred to as the shot noise limit (SNL) or sometimes the standard quantum limit (SQL), i.e., the general dependence at a large phase sensing photon number N. In order to reduce the vacuum quantum noise, squeezed states are properly injected into interferometers by replacing the vacuum state. The result of the squeezed state injection is the reduction of the detection noise below the shot noise level and thus the enhancement of phase measurement sensitivity. Experimental efforts and progress were made in the generation and application of these quantum states to optical interferometry systems.

SU(1,1) interferometers are a new type of quantum interferometers, which are quite different from the traditional interferometers in that the linear beam splitters are replaced by nonlinear optical devices of parametric amplifiers (PAs), as shown in Figure 1(b). The name of SU(1,1) stems from the type of interaction involved in parametric processes for nonlinear wave mixing.

The difference between SU(1,1) interferometers and traditional interferometers lies in the beam splitting and mixing elements. Parametric amplifiers are active quantum devices that generate quantum fields, whereas beam splitters are passive devices and rely on injection of quantum states to achieve quantum advantages. So, compared to the traditional interferometers with quantum state injections, SU(1,1) interferometers exhibit some distinct features that make them more desirable in practical applications. The first one is that the involvement of nonlinear optical processes for wave mixing allows the coherent superpositions of waves of different types such as atomic spin waves, light waves, and acoustic waves. This type of mixing is impossible for linear beam splitters. The second is that the employment of parametric amplifiers leads to amplified noise levels at outputs that are much larger than the vacuum noise level. This means the outputs are immune to losses, which are detrimental to quantum information because of the vacuum noise coupled in through the loss channels. The third is that the quantum entanglement generated by parametric amplifiers leads to correlated quantum noise, which can be cancelled at destructive interference. This gives rise to higher signal amplification than noise amplification and thus improved the signal-to-noise ratio (SNR) or enhanced sensitivity.

The wave splitting and superposition elements in an atom-light hybrid interferometer are Raman amplifiers, which are a special kind of parametric process. They are based on the optical pumping of the hyperfine structure of the ground state energy level (cf. Atom-Light Hybrid Quantum Gyroscope, PHYSICAL REVIEW APPLIED 14, 064023 (2020)). The Raman amplification process is illustrated in Figure 2. It consists of a simultaneous optical pump of the atomic vapor by using two lasers with wavelengths slightly higher (or lower) than the first $s \rightarrow p$ configuration transition and differing between each other by the hyperfine frequency splitting, depending on the alkali atom. The two lasers are called Write (black) and Stokes (gray). The lasers propagate jointly inside the interferometer.

The spin wave has an additional benefit with respect to a light beam in interferometric applications: it is localized in space and can be used as an antenna. The physical principle behind its use as an antenna is the AC Zeeman effect. It induces phase changes in the atomic spin wave and is caused by the interaction of a RF oscillating magnetic field with the atomic levels, causing shifts that affect the spin wave phase. Following this principle, a light-atom interferometer can be used as a sensor for RF signals by measuring their oscillating magnetic field in terms of an intensity modulation for the Stokes laser.

Such a sensor can measure RF signals over a large band (tens of GHz). Moreover, the sensitivity and dynamic range of such a measurement can be tuned by changing the optical delay length of the interferometer. The invention offers many expected advantages: small antenna dimensions (< $cm^3$), fully dielectric antenna for stealth applications, fiber-integrated detection scheme to avoid electromagnetic noise coming from the electronics, ultra-high bandwidth in the SHF spectrum, and tunable dynamical range spanning many orders of magnitude.

Such features translate into several applicative advantages, including:

- wideband signal monitoring, i.e., the ability to capture signals across a large frequency spectrum allows for comprehensive monitoring of various communication channels and technologies, facilitating the detection of multiple signals or events in real-time; the sensor can thus adapt to changing wireless communication environments and optimize bandwidth usage, particularly in congested areas;
- improved multi-channel capability, such a sensor can process several communication protocols and standards (e.g., Wi-Fi, Bluetooth, satellite, and cellular) simultaneously, making it highly versatile for applications in crowded frequency environments;
- interference identification and mitigation, by monitoring a wide frequency range, the sensor can quickly identify sources of interference, enabling better management and isolation of signals that may affect communication quality;
- reduced hardware requirements since a single sensor that covers a broad range of frequencies and dynamic ranges can simplify hardware architecture, reducing the need for multiple sensors and associated components, which can lead to lower costs, reduced size, and improved energy efficiency;
- reduced clipping and distortion since a tunable dynamic range helps to minimize the risk of signal clipping or distortion, which can occur when signals exceed the sensor's fixed dynamic range; this ensures cleaner and more faithful signal representation.

The RF sensor according to the present invention conveniently comprises different elements as shown in Figure 3. An optical control 11 is conveniently provided for creating the correct optical pulses and their time shifts for interacting correctly with the atomic vapor cell 12 to sense external RF AC magnetic fields 20. Moreover, an electrical control 13 conveniently grants access to electro-optical elements like intensity photodetectors and electro-optical modulators. Finally, an optical delay control 14 is conveniently provided to tune the sensitivity and dynamical range of the RF sensor.

The invention is based on the AC Zeeman effect that takes place in atoms when exposed to an external alternating magnetic field. The frequency shift between the ground and hyperfine level is proportional to the square of the applied field $B$ as per (cf. Experimental study of ac zeeman effect in 87Rb atomic frequency standard, ACTA PHYSICA SINICA, 5, 6 (1996)):

$$\Delta\nu \propto B^2 \cdot \frac{\omega_0 - \omega}{(\omega - \omega_0)^2 + \delta^2}$$

where $\omega_0$ is the frequency of the hyperfine transition (6.8 GHz for Rb), $\omega$ is the frequency of the RF signal, and $\delta \approx 10^3\,Hz$ is the longitudinal relaxation rate of atomic ground state.

This frequency shift will induce a phase shift on the spin wave as per (cf. Atom-Light Hybrid Interferometer, Phys. Rev. Lett. 115, 043602 (2015)):

$$\Delta\phi_a^{AC} \propto B^2 \cdot \frac{\omega_0 - \omega}{(\omega - \omega_0)^2 + \delta^2} \cdot \Delta t$$

The sensor will thus be linear in the RF power (scaling with $B^2$, i.e., with $E^2$ due to the electric and magnetic field relationship).

The highest sensitivity will be near the hyperfine resonance, at $\omega \sim \omega_0$, and will decrease symmetrically at lower and higher frequencies.

Recent experiments (cf. Atom-Light Hybrid Interferometer, Phys. Rev. Lett. 115, 043602 (2015)) have proven the relationship between a frequency shift of the hyperfine levels, as caused by external magnetic fields, and the phase shift. This relationship is quantified through the $\gamma$ coefficient:

$$\Delta\phi_a^{DC} = \gamma B \cdot \Delta t$$

where $\gamma \approx 10^8 \frac{rad}{G \cdot s}$ , with the magnetic field units being Gauss (1 G = 0.0001 T).

A similar frequency shift is obtained when the system is exposed to RF magnetic fields (cf. Experimental study of ac zeeman effect in 87Rb atomic frequency standard, ACTA PHYSICA SINICA, 5, 6 (1996)), as per the AC Zeeman effect, obtaining:

$$\Delta\phi_a^{AC} = \gamma^2 B^2 \cdot \frac{\omega_0 - \omega}{(\omega - \omega_0)^2 + \delta^2} \cdot \Delta t$$

Supposing $\omega - \omega_0 \sim 1\,GHz$, the equation can be converted to the form:

$$\Delta\phi_a^{AC} = \tilde{\gamma} B^2 \cdot \Delta t \qquad \left(\tilde{\gamma} \approx 10^7 \frac{rad}{G^2 \cdot s}\right)$$

and using $B^2 = 2I/c^3\varepsilon_0$, with $I$ being the RF power per unit area of the sensor ($W/cm^2$), and $\Delta t = L/c$ ($L$ being the propagation length)

$$\Delta\phi_a^{AC} = \Gamma I \cdot L \quad \left(\Gamma \simeq 10^{-2}\, \frac{rad}{m \cdot \frac{W}{cm^2}}\right)$$

This result tells us that, supposing an RF frequency of the order of a few GHz and a 100 m optical delay length, the sensor can measure powers down to the nanoWatt per square centimeter with modern photodiode detector technologies.

Moreover, the sensitivity and dynamic range of such a measurement can be tuned by changing the optical delay length L. When the optical delay increases, the sensitivity increases as per the formula above and the dynamic range decreases (the dynamic range is given by the power required to reach $\pi$ radiants in the interferometric signal). The optical length can be tuned freely up to km distances through the use of fiber loop mirrors and solid-state switches.

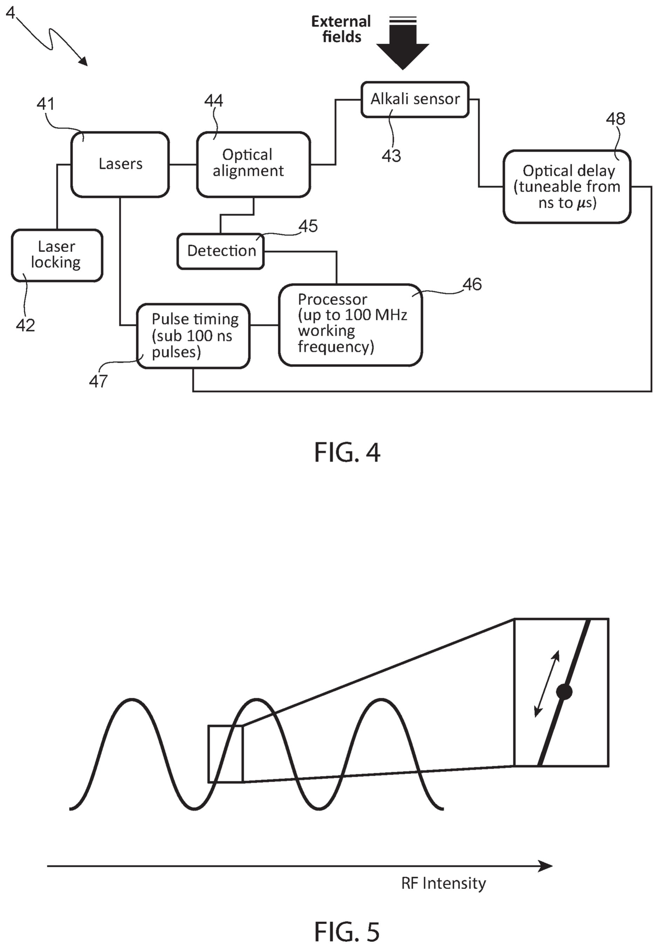

Figure 4 schematically illustrates an RF sensor (denoted as a whole by 4) according to a preferred, albeit non-limiting, non-binding, embodiment of the present invention.

The RF sensor comprises:

- lasers 41 coupled to respective laser locking means 42;
- an alkali sensor 43 made up of an alkali atomic vapor cell in a light-atom quantum interferometer;
- optical alignment means 44 arranged between the lasers 41 and the alkali sensor 43;
- detection means 45 configured to detect/measure laser light from the alkali sensor 43;
- a processor 46 configured to detect RF signals based on data/signals received from the detection means 45;
- pulse timing means 47 coupled to the lasers 41 and to the processor 46; and
- optical delay means 48 configured/operable to set optical delay length of optical delay line to tune sensitivity and dynamic range of the RF sensor 4.

The innovative parts of the technology reside in the exploitation of the AC Zeeman effect, the active control of the delay line to tune the sensitivity and dynamic range, and the use of the alkali cell of a light-atom interferometer as a sensor for the magnetic field of RF signals.

The device requires three lasers: a Write, a Stokes, and an eraser laser, whose frequency is locked to an atomic reference (the same alkali species as the sensor). The lasers, fully propagated in fibers, are converted into 100 ns or lower temporal pulses through electro-optical switches and are aligned inside the alkali sensor for the first nonlinear (Raman amplification) beam splitting of the phase between the atomic spin wave and the transmitted light. The transmitted pulses for the Write and Stokes lasers are then aligned into an optical delay line, tunable from ns to $\mu$s. During this propagation, the sensor will interact with the external fields for the entire delay time, until the Stokes and Raman pulses interact once again through a second Raman amplification process. The Stokes signal intensity transmitted back is monitored through a photodetector. The intensity value will depend on the phase interferometry between the light and the spin wave. The more the spin wave is modified by the external fields, the more changes are seen in the intensity interferometry.

Fiber loop mirrors can be used for the optical delay along with solid state switches (tuned to the pulse timing) to increase or decrease the delay length.

The interferometric signal will follow the pattern shown in Figure 5 as a function of the RF signal intensity. Variations in the intensity will cause a shift of the interferometric signal that is read by the photodetector as a change in laser power. The responsivity of the device can be made linear as shown in the inset.

The innovative features and technical advantages of the present invention are immediately clear from the foregoing.

In particular, it is important to note that the present invention concerns an innovative quantum sensor capable of addressing many drawbacks. It is designed to be sensitive to all frequencies within the Super High Frequency (SHF) spectrum simultaneously, achieving miniaturized antenna dimensions (below cubic centimeters) and providing a tunable dynamic range. Additionally, a fully optical fiber-integrated architecture facilitates greater separation between the antenna and the backend electronics, mitigating potential interference that could compromise the sensor's signal-to-noise ratio. This innovative approach not only enhances performance but also meets the critical demands posed by modern RF applications.

The present invention provides significant utility across a diverse set of industries and applications where RF sensing and monitoring are essential. Key sectors include wireless communication systems, electromagnetic compatibility (EMC) testing, military and defense operations, consumer electronics, and satellite communication, particularly in earth observation, communications, and navigation satellites.

The broad-spectrum capabilities of the present RF sensor enhance applications such as spectrum monitoring, signal intelligence (SIGINT), and radio astronomy. Moreover, the passive and broadband nature of the sensor grants access to the exploitation of signals of opportunity, which enables the sensor to detect and analyze incidental RF signals that may not be intentionally transmitted for monitoring purposes. This functionality can be especially beneficial in complex environments where active signal sources may be limited or difficult to manage.

In low Earth orbit (LEO) and geostationary orbits (GEO), the sensor significantly improves signal monitoring and interference detection, crucial for maintaining the integrity of communication systems. Further applications include space weather monitoring, where the sensor can effectively detect solar radiation effects impacting satellite systems, and payload health diagnostics by continuously monitoring the RF environment for anomalies that could adversely affect performance.

The sensor's advanced capabilities position it as a pivotal tool in the burgeoning field of satellite-based Internet of Things (IoT) and global positioning systems (GPS), where precise signal detection and analysis are of utmost importance. By leveraging signals of opportunity, alongside its robust monitoring capabilities, this RF sensor not only enhances existing applications but also opens new avenues for exploration and innovation in RF technology.

In conclusion, it is clear that numerous modifications and variants can be made to the present invention, all falling within the scope of the invention, as defined in the appended claims.

**Claims**

1. Device for sensing radiofrequency signals comprising:

   • a light-atom interferometer including an alkali atomic vapor cell;
   • lasers operable to illuminate the alkali atomic vapor cell with laser light to measure a radiofrequency oscillating magnetic field present in said alkali atomic vapor cell, wherein said radiofrequency oscillating magnetic field induces a phase change in the alkali atomic vapor based on AC Zeeman effect thereby inducing an intensity modulation of the laser light; and
   • a photodetector configured to detect the laser light from the alkali atomic vapor cell.

2. The device of claim 1, wherein the light-atom interferometer is a quantum SU(1,1) interferometer.

3. The device according to claim 1 or 2, wherein the alkali atomic vapor cell is based on rubidium or cesium atoms.

4. The device according to any claim 1-3, further comprising:

   • an optical delay line for propagation of the laser light outside the alkali atomic vapor cell; and
   • an optical control unit configured to set optical delay length of the optical delay line to tune sensitivity and dynamic range of the device for sensing radiofrequency signals.

5. The device according to any preceding claim, further comprising a processing unit programmed to:

   • receive from the photodetector data related to the laser light detected by said photodetector;
   • carry out a processing of the received data; and
   • determine an incident radiofrequency signal based on the processing carried out.

6. The device according to any preceding claim, designed to sense radiofrequency signals in super high frequency band.

(a)             (b)

FIG. 1

Spin wave     FIG. 2

FIG. 3

**FIG. 4**

RF Intensity

**FIG. 5**

**EUROPEAN SEARCH REPORT**

Europäisches
Patentamt
European
Patent Office
Office européen
des brevets

**Application Number**

**EP 26 15 1633**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/196716 A1 (ANDERSON DAVID A [US] ET AL) 23 June 2022 (2022-06-23) | 1,3-6 | INV.<br>G01R29/08 |
| A | * figures 5, 6 * | 2 | |
| X | ZHIFEI YU ET AL: "Sensing performance enhancement via asymmetric gain optimization in the atom-light hybrid interferometer", ARXIV.ORG, CORNELL UNIVERSITY LIBRARY, 201 OLIN LIBRARY CORNELL UNIVERSITY ITHACA, NY 14853, 11 January 2022 (2022-01-11), XP091137802, * figure 1b * | 1-3 | |

TECHNICAL FIELDS
SEARCHED (IPC)

G01R

The present search report has been drawn up for all claims

| Place of search | Date of completion of the search | Examiner |
|---|---|---|
| Munich | 28 January 2026 | Agerbaek, Thomas |

EPO FORM 1503 03.82 (P04C01)

**ANNEX TO THE EUROPEAN SEARCH REPORT**
**ON EUROPEAN PATENT APPLICATION NO.**                    EP 26 15 1633

This annex lists the patent family members relating to the patent documents cited in the above-mentioned European search report.
The members are as contained in the European Patent Office EDP file on
The European Patent Office is in no way liable for these particulars which are merely given for the purpose of information.

28-01-2026

| Patent document cited in search report | Publication date | Patent family member(s) | | Publication date |
|---|---|---|---|---|
| US 2022196716 A1 | 23-06-2022 | AU | 2021281437 A1 | 22-12-2022 |
| | | CA | 3178752 A1 | 02-12-2021 |
| | | EP | 4158363 A1 | 05-04-2023 |
| | | JP | 7719801 B2 | 06-08-2025 |
| | | JP | 2023531868 A | 26-07-2023 |
| | | JP | 2025169267 A | 12-11-2025 |
| | | US | 2022196716 A1 | 23-06-2022 |
| | | US | 2023243881 A1 | 03-08-2023 |
| | | US | 2025052800 A1 | 13-02-2025 |
| | | WO | 2021243260 A1 | 02-12-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 25151505
- IT 102025000021148

**Non-patent literature cited in the description**

- Atom light hybrid interferometer. *Phys. Rev. Lett.*, 2015, vol. 115, 043602
- Basic principles and applications. *APL Photon.*, 2020, vol. 5, 080902
- *Results in Physics*, 2024, vol. 58, 107465
- Atom-Light Hybrid Quantum Gyroscope. *PHYSICAL REVIEW APPLIED*, 2020, vol. 14, 064023
- Experimental study of ac zeeman effect in 87Rb atomic frequency standard. *ACTA PHYSICA SINICA*, 1996, vol. 5, 6
- Atom-Light Hybrid Interferometer. *Phys. Rev. Lett.*, 2015, vol. 115, 043602